# EUROPEAN PATENT APPLICATION

(11) **EP 4 478 402 A1**
(43) Date of publication of application: **18.12.2024**
(21) Application number: 22969067.2
(22) Date of filing: 29.12.2022
(51) Int. Cl.: H01L 21/762

(54) **SILICON SUBSTRATE ON INSULATOR AND PREPARATION METHOD THEREFOR**

(30) Priority: 21.12.2022 CN 202211652413
(71) Applicant: Zhonghuan Advanced Semiconductor Technology Co., Ltd., Wuxi, Jiangsu 214203 (CN)
(72) Inventor: MA, Qianzhi, Wuxi, Jiangsu 214203 (CN); SUN, Chenguang, Wuxi, Jiangsu 214203 (CN); WANG, Yanjun, Wuxi, Jiangsu 214203 (CN); YAO, Zuying, Wuxi, Jiangsu 214203 (CN); MA, Kun, Wuxi, Jiangsu 214203 (CN); ZHANG, Yuhang, Wuxi, Jiangsu 214203 (CN); ZHANG, Qi, Wuxi, Jiangsu 214203 (CN); WEI, Qiwang, Wuxi, Jiangsu 214203 (CN); LUO, Chaoyang, Wuxi, Jiangsu 214203 (CN); GU, Haiyun, Wuxi, Jiangsu 214203 (CN); LI, Zhicai, Wuxi, Jiangsu 214203 (CN)
(74) Representative: Herrero & Asociados, S.L.
(86) International application number: PCT/CN2022/143560
(87) International publication number: WO 2024/130781

(57) **Abstract**

Disclosed a silicon-on-insulator substrate and a preparation method thereof, comprisng: providing a first semiconductor wafer, the first semiconductor wafer comprises a first oxide layer and a first substrate silicon layer, the first oxide layer is formed through separation by implanted oxygen, providing a second semiconductor wafer; bonding the first semiconductor wafer and the second semiconductor wafer to form a third semiconductor wafer, performing a first annealing; performing mechanical grinding on the first substrate silicon layer and thinning; performing chemical mechanical polishing on the first substrate silicon layer to polish to the surface of the first oxide layer; performing a second annealing; etching the first oxide layer by using a chemical etchant to obtain the silicon-on-insulator substrate. This application uses chemical mechanical polishing instead of alkali etching to avoid the silicon island defect from extending below the oxide layer after being etched by alkali, and adds a second annealing and introduces oxygen to oxidize the silicon island defects to facilitate the subsequent removal, thereby obtaining silicon-on-insulator substrate with a low defect density.

## Description

### CROSS-REFERENCE TO RELATED APPLICATIONS

This application claims the benefit of Chinese Patent Application No. 202211652413.9 filed on Dec. 21, 2022 and entitled "SILICON-ON-INSULATOR SUBSTRATE AND PREPARATION METHOD THEREOF", the disclosures of which are incorporated by reference herein in their entirety.

### TECHNICAL FIELD

The application relates to the technical field of integrated circuit materials, and in particular, relates to a silicon-on-insulator substrate and a preparation method thereof.

### BACKGROUND

As an engineering substrate wafer, silicon-on-insulator substrate becomes a semiconductor material with a sandwich structure of top layer device silicon layer / buried oxide layer / supporting substrate silicon layer, through unique technical means to introduce a uniformly distributed oxide layer called buried oxide layer based on conventional polished wafer. The silicon-on-insulator substrate has advantages that bulk silicon cannot match: achieving completely physical isolation of components in integrated circuits, completely eliminating the parasitic latch-up effect in the bulk silicon Complementary Metal-Oxide-Semiconductor (CMOS) circuit; attracting much attention because of obvious advantages in power consumption, operating speed, radiation resistance and device integration. In recent years, with the continuous advancement of process technology, the preparation of silicon-on-insulator substrate has been rapidly developed. The thickness of the silicon layer of the top device and the thickness of the buried oxide layer of the wafer prepared by Separation by Implanted Oxygen (SIMOX) are very uniform, however, due to the limitation of the implanting process of the oxygen ion, the thickness of the device silicon layer cannot exceed 300 nm, the thickness of the buried oxide layer cannot exceed 240 nm, and in the buried oxide layer, some discontinuous silicon island defects are often found, which makes the breakdown voltage of the buried oxide layer much worse than that of conventional thermal oxidation, the top layer device silicon layer generates a large amount of lattice damage dut to the ion implantation process, these lattice damage is not repaired in time and presents dislocation defect, thus limiting the product application and technological development of Separation by Implanted Oxygen.

The conventional oxygen implantation bonding process is based on oxygen ion implanted to form an initial silicon-on-insulator substrate material, then bonding and thinning with another supporting semiconductor wafer substrate, utilizing the etching selectivity of the implanted buried oxide layer to achieve a monocrystalline silicon layer transferring to a supporting silicon wafer substrate. However, during process of the oxygen ion implantation, the continuity and density of the buried oxide layer formed by the oxygen ion implantation is poorer than the conventional thermal oxide layer, and it is easy to produce some silicon channels similar to "silicon islands", these silicon channels are removed during the process of selectively etching, pinhole is formed to affect the device silicon layer disposed under the buried oxide layer and create etch pit, the crystal quality of the silicon-on-insulator substrate is affected, the risk of device leakage and failure is created.

### TECHNICAL PROBLEM

The present application provides a silicon-on-insulator substrate and a preparation method thereof, which solves the problem of high defect density of the top silicon layer of the silicon-on-insulator substrate currently prepared by oxygen implantation bonding process.

### BRIEF SUMMARY OF THE INVENTION

According to the preparation method of a silicon-on-insulator substrate in the first embodiment of the present application, comprises:
providing a first semiconductor wafer, the first semiconductor wafer comprises a first monocrystalline silicon layer, a first oxide layer and a first substrate silicon layer, the first oxide layer is disposed between the first monocrystalline silicon layer and the first substrate silicon layer, wherein, the first oxide layer is formed through separation by implanted oxygen;
providing a second semiconductor wafer, the second semiconductor wafer comprises a second substrate silicon layer and a second oxide layer disposed on the second substrate silicon layer;
bonding the first semiconductor wafer and the second semiconductor wafer to form a third semiconductor wafer, performing a first annealing on the third semiconductor wafer;
performing mechanical grinding on the first substrate silicon layer to thin the first substrate silicon layer;
performing chemical mechanical polishing on the first substrate silicon layer to polish to the surface of the first oxide layer;
performing a second annealing on the third semiconductor wafer, introducing argon and oxygen during the process of the second annealing;
etching the first oxide layer by using a chemical etchant to obtain the silicon-on-insulator substrate.

Optionally, in other embodiments of the present application, disposing the first semiconductor wafer on the second semiconductor wafer, and contacting the first monocrystalline silicon layer with the second oxide layer to form the third semiconductor wafer by bonding.

Optionally, in other embodiments of the present application, the second oxide layer is a thermal oxide layer formed by dry oxygen oxidation or wet oxygen oxidation.

Optionally, in other embodiments of the present application, the temperature of the first annealing is lower than the temperature of the second annealing.

Optionally, in other embodiments of the present application, in the first annealing, the annealing temperature is 300 °C to 700 °C, the annealing duration is 2 hours to 4 hours.

Optionally, in other embodiments of the present application, in the second annealing, the annealing temperature is 800 °C to 1200 °C, the annealing duration is 4 hours to 6 hours, the oxygen partial pressure ratio is 3% to 20%.

Optionally, in other embodiments of the present application, after the first annealing, the bonding force of the third semiconductor wafer is greater than or equal to 1.5 J/m²; after the second annealing, the bonding force of the third semiconductor wafer is greater than or equal to 2 J/m².

Optionally, in other embodiments of the present application, the duration of the mechanical grinding and thinning is t₁ min, the duration of the chemical mechanical polishing is t₂ min, satisfying: 10 ≤ t₁ + t₂ ≤ 20.

Optionally, in other embodiments of the present application, the duration of the mechanical grinding and thinning is t₁ min, the duration of the chemical mechanical polishing is t₂ min, satisfying: 5 ≤ t₁ ≤ 10, and 5 ≤ t₂ ≤ 10.

Optionally, in other embodiments of the present application, in the step of mechanical grinding, after the first substrate silicon layer is thinned, the thickness of the first substrate silicon layer obtained is 5 to 10µm.

Optionally, in other embodiments of the present application, after the mechanical grinding and thinning, the thinned first substrate silicon layer is obtained, the thinned first substrate silicon layer comprises a reserved damage layer.

Optionally, in other embodiments of the present application, in the step of the chemical mechanical polishing, removing the reserved damage layer firstly, then stop when polishing to the surface of the first oxide layer.

Optionally, in other embodiments of the present application, the thickness of the reserved damage layer is 3 to 5µm.

Optionally, in other embodiments of the present application, the pH value of the slurry adopted by the chemical mechanical polishing is greater than or equal to 10.5, the particle size of the slurry is less than or equal to 50 nm.

Optionally, in other embodiments of the present application, the temperature of the chemical mechanical polishing is 20 °C to 40 °C, the removal rate of the chemical mechanical polishing is 0.5µm/min to 1µm/min.

Optionally, in other embodiments of the present application, the chemical etchant comprises a hydrofluoric acid solution, the concentration of the hydrofluoric acid solution is 3 % to 20 %, the temperature of the hydrofluoric acid solution is 20 °C to 40 °C.

According to the silicon-on-insulator substrate in the second embodiment of the present application, the silicon-on-insulator substrate is prepared by the above mentioned preparation method, the silicon-on-insulator substrate comprises a top silicon layer, an oxide layer and a substrate silicon layer arranged in sequence from top to bottom, the number of particles of the surface defect of the top silicon layer is less than or equal to 5.

Optionally, in other embodiments of the present application, the thickness of the oxide layer is 20 to 4000 nm.

### BENEFICIAL EFFECT

The preparation method of a silicon-on-insulator substrate according to the embodiment of the present application has at least the following technical effects:
(1) This application uses a chemical mechanical polishing process instead of an alkali etching process, to remove the first substrate silicon layer after being ground and thinned in the post-bonding third semiconductor wafer and automatically stops at the surface of the first oxide layer as a barrier layer, avoids the pinhole defects after being etched by alkali from extending below the first oxide layer, thereby reducing the surface defect of the monocrystalline silicon layer below the first oxide layer;
(2) The present application introduces a second annealing, using the way of high-temperature annealing, during the annealing process, oxygen is introduced to oxidize all silicon island defects into silicon dioxide that can be corrosively removed by hydrofluoric acid, a silicon-on-insulator substrate material with low defect density is obtained finally.

### BRIEF DESCRIPTION OF THE DRAWINGS

In order to more clearly illustrate the technical solutions in the embodiments of the present application, the drawings needed to be used in the description of the embodiments will be briefly introduced below, obviously, the drawings in the following description are only some embodiments of the present application, for those skilled in the art, other drawings can also be obtained based on these drawings without exerting creative efforts.
FIG. 1 is a flow chart of a preparation method of a silicon-on-insulator substrate provided by an embodiment of the present application;
FIG. 2 is a schematic diagram of the traditional oxygen implantation bonding process;
FIG. 3 is a schematic diagram of the oxygen implantation bonding process of the present application;
FIG. 4 is a schematic diagram of the first semiconductor wafer;
FIG. 5 is a schematic diagram of the second semiconductor wafer;
FIG. 6 is a schematic diagram of the semiconductor wafer obtained in step S2;
FIG. 7 is a schematic diagram of the semiconductor wafer obtained in step S3;
FIG. 8 is a schematic diagram of the semiconductor wafer obtained in step S4;
FIG. 9 is a schematic diagram of the semiconductor wafer obtained in step S5;
FIG. 10 is a schematic diagram of the semiconductor wafer obtained in step S6;
FIG. 11 is a schematic structural diagram of silicon-on-insulator substrate of an embodiment of the present application;
FIG. 12 is a schematic diagram of surface defect of a silicon-on-insulator substrate of an embodiment of the present application;
FIG. 13 is a schematic diagram of surface defect of a silicon-on-insulator substrate prepared by a traditional oxygen implantation bonding process.

Reference numerals in the figures are respectively indicated as: 1-first semiconductor wafer, 11-first monocrystalline silicon layer, 12-first oxide layer, 13-first substrate silicon layer, 2-second semiconductor wafer, 21-second oxide layer, 22-second substrate silicon layer, 3-third semiconductor wafer, 41-top silicon layer, 42-oxide layer, 43-substrate silicon layer, 51-silicon island defect, 52-channel, 53-etch pit.

### IMPLEMENTATIONS OF THIS APPLICATION

The following clearly and completely describes the technical solutions in embodiments of this application with reference to the accompanying drawings in embodiments of this application. It is clear that the described embodiments are merely some but not all of embodiments of this application. All other embodiments obtained by a person skilled in the art based on embodiments of this application without creative efforts shall fall within the protection scope of this application.

Embodiments of the present application provides a silicon-on-insulator substrate and a preparation method thereof. Each is explained in detail below. It should be noted that the order of description of the following embodiments does not limit the preferred order of the embodiments.

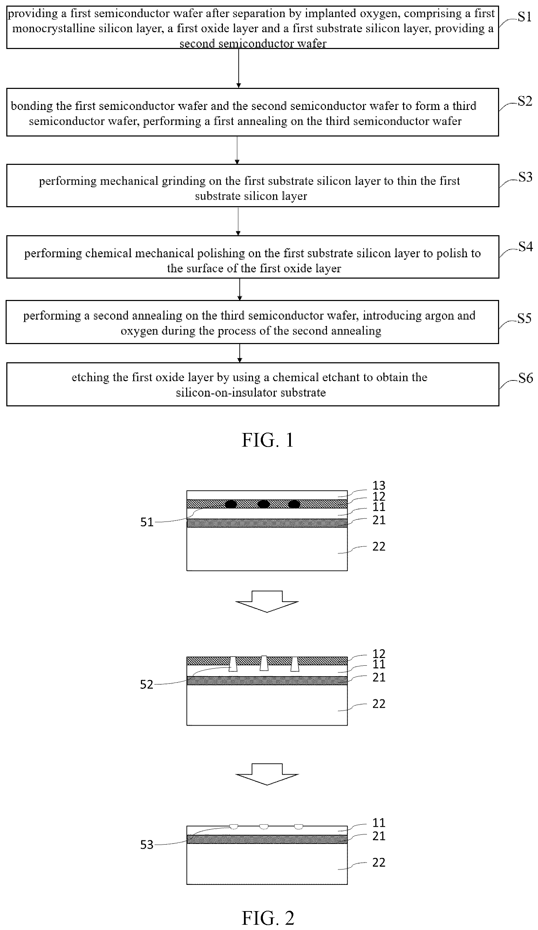

Please refer to FIG. 1, an embodiment of the present application provides a silicon-on-insulator substrate and a preparation method thereof, comprises:
Step S1: providing a first semiconductor wafer 1, the first semiconductor wafer 1 comprises a first monocrystalline silicon layer 11, a first oxide layer 12 and a first substrate silicon layer 13, the first oxide layer 12 is disposed between the first monocrystalline silicon layer 11 and the first substrate silicon layer 13; providing a second semiconductor wafer 2, the second semiconductor wafer 2 comprises a second substrate silicon layer 22 and a second oxide layer 21 disposed on the second substrate silicon layer 22, wherein, the first oxide layer 12 is formed through separation by implanted oxygen, unoxidized silicon exists in the first oxide layer 12, the first oxide layer 12 comprises silicon oxide and unoxidized silicon between silicon oxide, so that the silicon oxide in the first oxide layer 12 is discontinuous;
Step S2: bonding the first semiconductor wafer 1 and the second semiconductor wafer 2 to form a third semiconductor wafer 3, performing a first annealing on the third semiconductor wafer 3; the purpose of performing the first annealing on the third semiconductor wafer 3 is to initially improve the bonding force, a lower annealing temperature is to control the thermal budget, and reduce the thermal budget through a lower first annealing temperature;
Step S3: performing mechanical grinding on the first substrate silicon layer 13to thin the first substrate silicon layer 13; add a mechanical grinding step before chemical mechanical polishing, the total thinning duration is reduced; at the same time, during the process of thinning the first substrate silicon layer 13 will cause damage, it is necessary to control the thickness of the thinning during the process of thinning, and reserve a damaged layer, the damaged layer will be removed through subsequent chemical mechanical polishing step;
Step S4: performing chemical mechanical polishing (CMP) on the first substrate silicon layer 13, automatically stop when polishing to the surface of the first oxide layer 12; in this step, chemical mechanical polishing removes the above mentioned reserved damage layer firstly, then automatically stop when polishing to the surface of the first oxide layer 12, so as to expose the first oxide layer 12, the silicon still exists in the first oxide layer 12 is completely oxidized in the second annealing to form a continuous oxide layer;
Step S5: performing a second annealing on the third semiconductor wafer 3, introducing argon and oxygen during the process of the second annealing; one aspect of the purpose of the second annealing is to further enhance boding force, the other aspect is to strictly control the second annealing temperature, in case where the temperature is higher than the first annealing temperature, the temperature and duration of the second annealing are reasonably controlled to further control the thermal budget, in addition, after the second annealing, the aforementioned discontinuous oxide layer that still exists in the first oxide layer 12 has been completely oxidized;
Step S6: etching the first oxide layer 12 by using a chemical etchant to obtain the silicon-on-insulator substrate; when the chemical etchant removes the first oxide layer 12, after verification of subsequent defective particles, there are no pinhole and channel 52 during the the process of the chemical etchant etching the first oxide layer 12.

It should be noted that the above steps are all necessary steps, and the order cannot be changed.

This application uses oxygen implantation bonding technology to prepare silicon-on-insulator substrate. The wafer is prepared by separation by implanted oxygen technology, oxygen atoms are injected into the wafer, and then annealed at high temperature to cause the oxygen atoms to react with the surrounding silicon atoms to generate a layer of silicon dioxide. The difficulty of this technology is to control the depth and thickness of oxygen ion implantation. Moreover, some discontinuous silicon island defects 51 are often found in the oxide layer. Due to the existence of the silicon island defect 51, subsequent bonding step is usually not performed, or even if bonding technology is used, the problem of the silicon island defect 51 in the oxide layer generated in the separation by implanted oxygen technology will be ignored or unable to be solved.

This application uses oxygen implantation bonding technology, replacing the traditional alkali etching process by using CMP technology; this application performs mechanical grinding firstly on the post-bonding third semiconductor wafer 3, and then performs chemical mechanical polishing, and automatically stops at the surface of the first oxide layer 12 as a barrier layer, reduces the duration of chemical mechanical polishing; at the same time, after the chemical mechanical polishing, the first oxide layer 12 is exposed, and the first oxide layer 12 is completely oxidized through the second annealing to avoid from forming the pinhole which results in the pinhole after alkali etching extending to form channel 52 below the first oxide layer 12, thereby the surface defect of the first monocrystalline silicon layer 11 below the first oxide layer 12 is reduced.

This application provides a first semiconductor wafer 1 and a second semiconductor wafer 2 after separation by implanted oxygen, the first semiconductor wafer 1 and the second semiconductor wafer 2 are bonded, the bonding force is enhanced through the first annealing. Since the efficiency of thinning the first substrate silicon layer 13 will be reduced by only using CMP technology, this application first uses mechanical grinding to partially thin the first substrate silicon layer 13, and then uses CMP technology to polish to the surface of the first oxide layer 12 to remove the reserved damage layer caused by mechanical grinding, and the first oxide layer 12 is exposed. Since the silicon island defect 51 still exists in the first oxide layer 12 at this time, then, through a second annealing and introduction of the oxygen at the same time, all the silicon island defects 51 are oxidized into silicon dioxide that can be corrosively removed by hydrofluoric acid, a silicon-on-insulator substrate material with low defect density is obtained finally.

Pleases refer to FIG. 2, the conventional oxygen implantation bonding process is based on oxygen ion implanted to form an initial silicon-on-insulator substrate material, then bonding and thinning with another supporting semiconductor wafer substrate, utilizing the etching selectivity of the implanted buried oxide layer to achieve a monocrystalline silicon layer transferring to a supporting silicon wafer substrate. However, during the process of the oxygen ion implantation, particles are generated due to the bombardment of oxygen ions on the surface of the silicon, and these particles will generate a Mask blocking effect, the silicon is not completely oxidized into silicon oxide, and part of the silicon is mixed in the oxide layer, causing the implantation layer to generate a discontinuous oxide layer, which is the precursor of the pinhole exists between the oxide layers, that is, silicon island defect 51; the conventional oxygen implantation bonding process uses a selective chemical etching solution (tetramethylammonium hydroxide or potassium hydroxide) process to remove the remaining first substrate silicon layer 13 on the first oxide layer 12, the silicon island defect 51 in the first oxide layer 12 will be etched away by alkali to form a pinhole, the alkali liquid will penetrate the pinhole, the pinholes will be connected to form a channel 52 that the corrosive liquid can penetrate, the channel 52 both exists in the first oxide layer 12 and the first monocrystalline silicon layer 11, so that the first monocrystalline silicon layer 11 below the first oxide layer 12 forms a etch pit 53, the stronger the alkali solution etches, the deeper the corrosion pit 53 is.

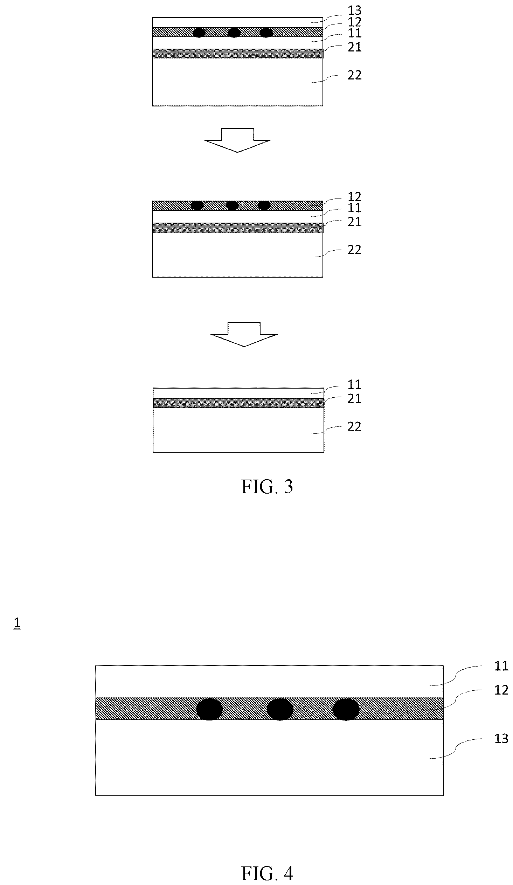

Please refer to FIG. 3, this application uses selective chemical mechanical polishing instead of selective chemical etching to remove the remaining first substrate silicon layer 13 on the first oxide layer 12, since the chemical mechanical polishing automatically stops when polishing to the surface of the first oxide layer 12, and the corrosive ability of the slurry used in chemical mechanical polishing is much smaller than that of the alkali etching solution, therefore the etch pit 53 caused to the first monocrystalline silicon layer 11 below are much smaller than the etch pit 53 of the conventional oxygen implantation bonding process. At the same time, this application introduces a second annealing step after chemical mechanical polishing, during the second annealing, oxygen is introduced to oxidize the silicon island defect 51 at high temperature to convert into silicon dioxide components which can be removed through subsequent hydrofluoric acid etching, thereby forming a low defect density silicon-on-insulator substrate.

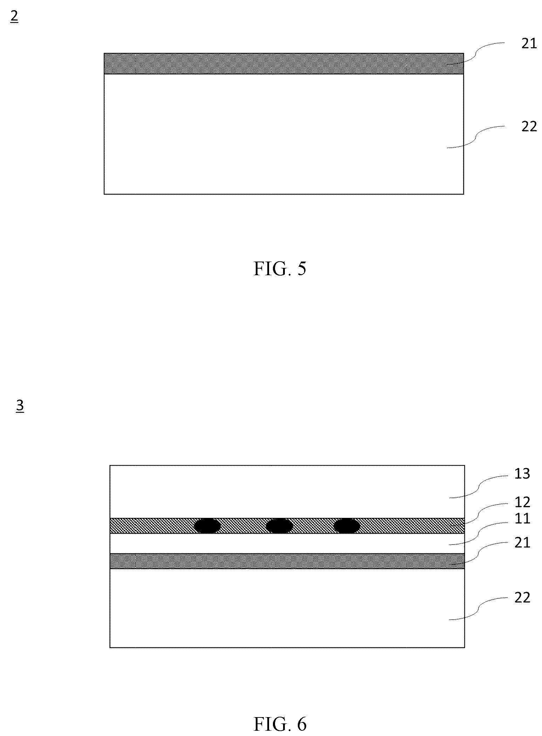

In step S1, as shown in FIG. 4 and FIG. 5, providing a first semiconductor wafer 1 and a second semiconductor wafer 2. The first semiconductor wafer 1 is formed by separation by implanted oxygen, and an ion implantation process is used to form the first oxide layer 12 in the silicon wafer. The thickness of the first monocrystalline silicon layer 11 and the first oxide layer 12 of the first semiconductor wafer 1 prepared by the separation by implanted oxygen technology is very uniform, but due to limitations of the oxygen ion process, the thickness of the first oxide layer 12 cannot be adjusted in a wide range. And due to partial region of the surface of the first oxide layer 12 is shielded by particles during the implantation process, discontinuous oxide layers are generated, a large number of silicon island defects 51 exist in these discontinuous oxide layers. The surface of the second semiconductor wafer 2 grows a thermal oxide layer on the basis of a conventional czochralski monocrystalline substrate wafer or a zone melting monocrystalline substrate wafer, the thermal oxide layer is formed by using dry oxygen oxidation or wet oxygen oxidation, the compactness and the continuity of the thermal oxide layer is better than the first oxide layer 12, and the thickness of the second oxide layer 21 can be adjusted within a wide range. Dry oxygen oxidation only uses pure oxygen, so the growth rate of the oxide layer is slow and mainly used to form thin films and can form oxides with good conductivity. Wet oxygen oxidation uses oxygen and highly soluble water vapor at the same time. Therefore, the oxide layer grows quickly and a thicker oxide layer will be formed. However, compared with dry oxygen oxidation, the density of the oxide layer formed by wet oxygen oxidation is low. Generally, at the same temperature and duration, the oxide layer obtained by wet oxygen oxidation is about 5 to 10 times thicker than that obtained by dry oxygen oxidation. The thickness of the second oxide layer 21 can be between 20 and 4000 nm. Oxygen implantation bonding the first semiconductor wafer 1 and the second semiconductor wafer 2 through the method of the present application to form a silicon-on-insulator substrate, not only the thickness of the oxide layer is adjustable and the top silicon layer is relatively uniform, but also can significantly reduce the surface defects of the top silicon layer through the method of the present application.

In step S2, disposing the first semiconductor wafer 1 on the second semiconductor wafer 2, and contacting the first monocrystalline silicon layer 11 of the first semiconductor wafer 1 with the second oxide layer 21 of the semiconductor wafer 2 to bond and obtain the third semiconductor wafer 3 as shown in FIG. 6. In order to ensure that the first semiconductor wafer 1 and the second semiconductor wafer 2 have sufficient bonding strength to prevent the first semiconductor wafer 1 from falling off during the subsequent thinning process, the first annealing is performed, and in order to reduce the thermal budget, therefore, the first annealing temperature is in a relatively low range.

In some embodiments of the present application, the temperature of the first annealing is lower than the temperature of the second annealing. The temperature of the first annealing can be between 300 °C and 700 °C, the annealing temperature can also be 400 °C to 600 °C, the annealing temperature can also be 500 °C; the duration of the first annealing can be 2 to 4 hours, or can be 3 hours.

In some embodiments of the present application, after the first annealing, the bonding force of the third semiconductor wafer 3 is greater than or equal to 1.5 J/m². By performing the first annealing, the bonding force of the third semiconductor wafer 3 is increased to prevent the first semiconductor wafer 1 from falling off during the subsequent thinning process.

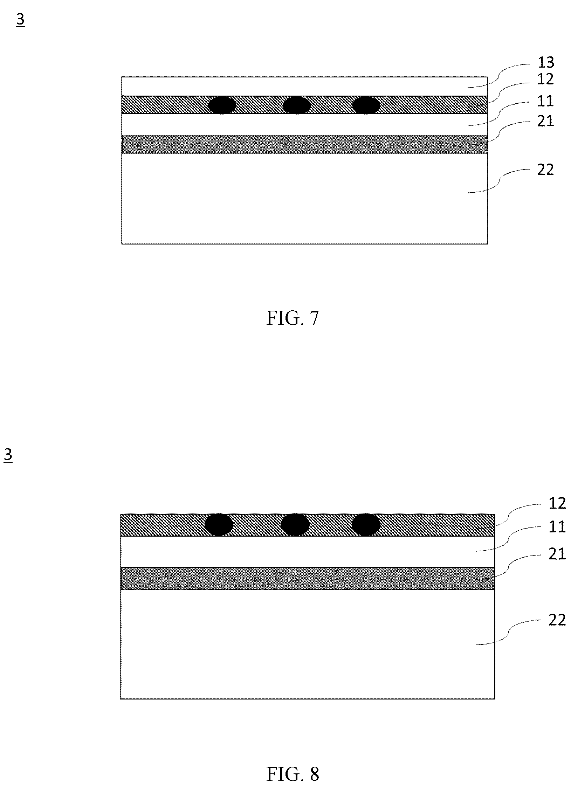

In step S3, performing mechanical grinding on the post-bonding third semiconductor wafer 3 to obtaim the semiconductor wafer as shown in FIG. 7. Use a coarse grinding wheel with a mesh size smaller than 800 to perform one grinding firstly, and then use a fine grinding wheel with a mesh size greater than 3000 to perform secondary grinding. In step S4, performing selective chemical mechanical polishing on the third semiconductor wafer 3 which has been ground to obtain the semiconductor wafer as shown in FIG. 8. When polishing to the first oxide layer 12, since the slurry can only polish and remove silicon but not silicon oxide, thus will automatically stop at the surface of the first oxide layer 12. Moreover, the etching ability of the slurry used in chemical mechanical polishing is much smaller than that of the alkali etching solution used in conventional processes, so the etch pit 53 caused to the first monocrystalline silicon layer 11 below is much smaller than the etch pit 53 in the conventional oxygen implantation bonding process.

In some embodiments of the present application, the duratioin of the mechanical grinding and thinning is t₁ min, and the duration of the chemical mechanical polishing is t₂ min, satisfying: 10 ≤ t₁ + t₂ ≤ 20. In some embodiments of the present application, 12 ≤ t₁ + t₂ ≤ 18. In some embodiments of the present application, 14 ≤ t₁ + t₂ ≤ 16.

In some embodiments of the present application, the duration of the mechanical grinding and thinning is t₁ min, and the duration of the chemical mechanical polishing is t₂ min, satisfying: 5 ≤ t₁ ≤ 10, and 5 ≤ t₂ ≤ 10. For example, t₁ can be 6, 7, 8, 9 or a range composed of any two of these values; t₂ can be 6, 7, 8, 9 or a range composed of any two of these values. In some embodiments of the present application, 6 ≤ t₁ ≤ 9, and 6 ≤ t₂ ≤ 9. In some embodiments of the present application, 7 ≤ t₁ ≤ 8, and 7 ≤ t₂ ≤ 8.

In some embodiments of the present application, the removal rate of chemical mechanical polishing is 0.5µm/min to 1µm/min, and can also be 0.6µm/min to 0.8µm/min.

In some embodiments of the present application, in the step of the mechanical grinding, after the first substrate silicon layer is thinned, the thickness of the first substrate silicon layer obtained can be 5 to 10µm, or can be 6 to 9µm, or can be 7 to 8µm.

In some embodiments of the present application, after the mechanical grinding and thinning, a thinned first substrate silicon layer is obtained, and the thinned first substrate silicon layer comprises a reserved damage layer.

In some embodiments of the present application, in the step of the chemical mechanical polishing, the reserved damage layer is removed firstly, and then stops when polishing to the surface of the first oxide layer.

In some embodiments of the present application, the thickness of the reserved damage layer is 3 to 5µm, and can also be 4µm.

Due to the efficiency of directly using CMP technology to the first substrate silicon layer is relatively low, the rate of the CMP is approximately 0.5 µm/min to 1µm/min, and it takes hundreds of minutes to prepare a wafer of several hundred microns. Therefore, in order to improve efficiency, performing partially thinning on the first substrate silicon layer 13 by using mechanical grinding, but a reserved damage layer will be introduced during mechanical grinding. Afterwards, CMP technology is used to polish to the surface of the first oxide layer 12 to remove the reserved damaged layer caused by mechanical grinding and expose the first oxide layer 12. Through the combined use of the mechanical grinding and CMP technology, not only can improve the efficiency of thinning, save the preparation duration of silicon-on-insulator substrate, but also can ensure the removal amount of the silicon layer. Furthermore, by controlling the thickness of the reserved damage layer and the first substrate silicon layer 13 thinned by mechanical grinding, mechanical grinding will not cause damage to the first oxide layer 12, ensuring the integrity of the first oxide layer 12.

Furthermore, the pH value of the slurry adopted by the chemical mechanical polishing is greater than or equal to 10.5, or can be greater than or equal to 11; the particle size of the slurry is less than or equal to 50 nm, or can be less than or equal to 45 nm, or can be less than or equal to 40 nm. When the pH value and particle size of the slurry are within the above range, the slurry has better selectivity of removing to the silicon, thereby reducing the impact to the first oxide layer 12 below and further reducing the formation of surface defect.

Furthermore, the temperature of the chemical mechanical polishing can be 2 0°C to 40 °C, or can be 30 °C.

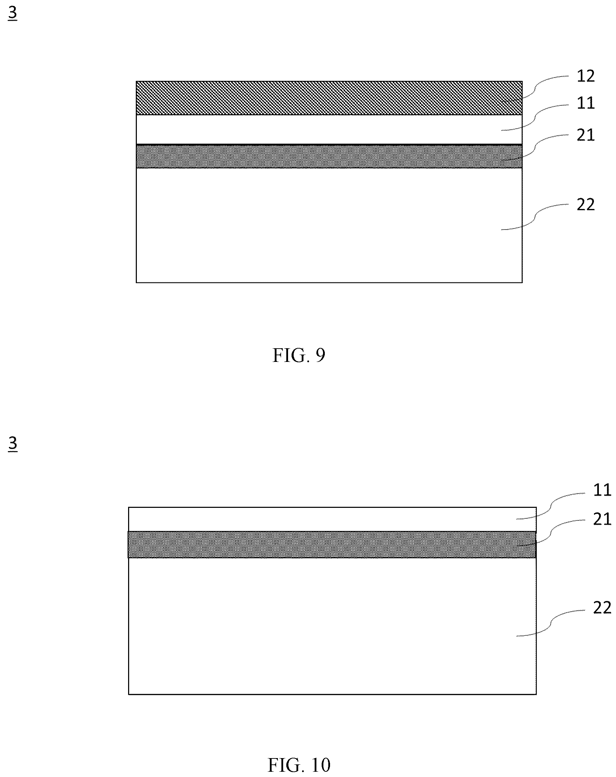

In step S5, putting the polished third semiconductor wafer 3 into the annealing furnace, performing a second annealing to obtain the semiconductor wafer as shown in Figure 9; the second annealing can not noly improve the bonding strength, more importantly, oxygen is introduced to oxidize the silicon island defect 51 at high temperature to convert into silicon dioxide components which can be removed through subsequent hydrofluoric acid etching.

In some embodiments of the present application, in the second annealing, the annealing temperature can be 800 °C to 1200 °C, or can be 900 °C to 1100 °C, or can be 1000 °C; the second annealing duratioin can be 4 to 6 hours, or can be 5 hours; during the process of the annealing, the heating rate is 2 to 4 °C/min, and the cooling rate is 3 to 5 °C/min. Argon and oxygen are introduced during the process of the annealing, wherein the oxygen partial pressure ratio can be 3 % to 20 %, or can be 5 % to 15 %, or can be 10 % to 13 %.

In some embodiments of the present application, after the second annealing, the bonding force of the third semiconductor wafer is greater than or equal to 2 J/m². The second annealing can not only oxidize the silicon island defects 51 in the first oxide layer 12, but also can improve the bonding force.

Adding a second annealing on the basis of the first annealing, not only further improves the bonding strength of the third semiconductor wafer 3, at the same time, separating the annealing into two times, can reduce the temperature and the duratioin of the annealing, thereby reducing the thermal budget.

In step S6, using a diluted HF solution to etch the annealed first oxide layer 12, finally obtain a semiconductor wafer as shown in FIG. 10. In order to avoid the second oxide layer 21 on the back surface from being etched and removed, a monolithic spin etching method is used to spin-coat the HF solution on the surface of the first oxide layer 12 to remove the ion implantation layer.

In some embodiments of the present application, the concentration of the HF can be 3 % to 20 %, or can be 5 % to 15 %, or can be 10 % to 13 %. The rotation speed of the semiconductor wafer is 300 to 2000 RPM/min. Using an ice machine to control the temperature of the HF solution, the temperature range can be between 20 °C and 40 °C, or can be 30 °C.

Since this application uses chemical mechanical polishing instead of selective chemical etching to remove the remaining first substrate silicon layer 13 on the first oxide layer 12, therefore the etch pit 53 caused to the first monocrystalline silicon layer 11 below are much smaller than the etch pit 53 of the conventional oxygen implantation bonding process. In addition, by performing the chemical mechanical polishing to remove the first substrate silicon layer 13 after being ground and thinned in the post-bonding third semiconductor wafer 3 and automatically stop at the surface of the first oxide layer as a barrier layer, thereby exposing the first oxide layer 12, facilitating the subsequent second annealing to completely oxidize the discontinuous oxide layer. On this basis, through the second annealing, a high-temperature annealing method is used, oxygen is introduced during the annealing process to oxidize all of the silicon island defects 51 into silicon dioxide that can be removed by hydrofluoric acid etching. Afterwards, the first oxide layer 12 and the silicon island defects 51 therein can be completely removed by chemical etching agents such as hydrofluoric acid, and finally a silicon-on-insulator substrate material with a low surface defect density is obtained. The effect of low defect density is verified by detecting the number of defect particles on the top silicon layer.

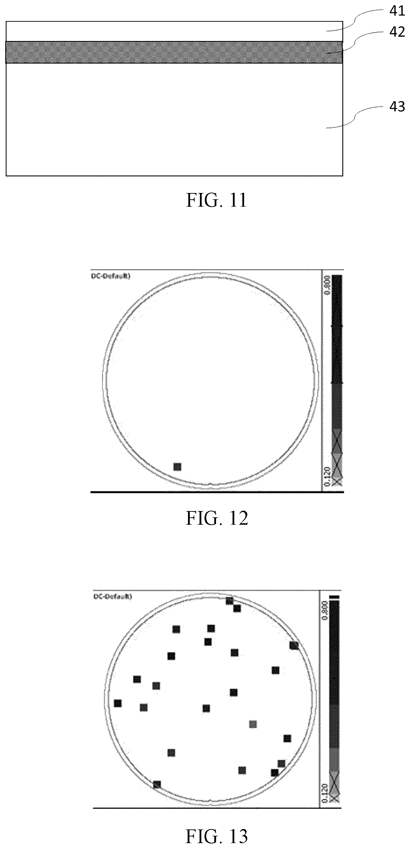

Please refer to FIG. 11, an embodiment of the present application also provides a silicon-on-insulator substrate, the silicon-on-insulator substrate is prepared by the preparation method mentioned above, the silicon-on-insulator substrate comprises a top silicon layer 41, an oxide layer 42 and a substrate silicon layer 43 in sequence from top to bottom, the number of particles of the surface defect of the top silicon layer 41 is less than or equal to 5 (particle diameter is greater than or equal to 0.12µm). The silicon-on-insulator substrate prepared by the preparation method mentioned above, the number of particles of the surface defect of the top silicon layer 41 is significantly reduced.

Furthermore, the thickness of the oxide layer 42 can be 20 nm to 4000 nm, or can also be 50 nm to 3000 nm, or can be 1000 nm to 2000 nm. The silicon-on-insulator substrate prepared by the method mentioned above can not only reduce the surface defect, but also can adjust the thickness of the oxide layer 42 within a wide range.

Description will be made below with reference to specific embodiments.

### Example 1

This embodiment provides a preparation method of a silicon-on-insulator substrate, comprising the following steps:
1) providing a SIMOX wafer of separation by implanted oxygen as the first semiconductor wafer 1, the first semiconductor wafer 1 comprises a first monocrystalline silicon layer 11, a first oxide layer 12 and a first substrate silicon layer 13; providing a second semiconductor wafer 2, the surface of the second semiconductor wafer 2 grows a thermal oxide layer on the basis of a conventional czochralski monocrystalline substrate wafer or a zone melting monocrystalline substrate wafer;
2) bonding the first semiconductor wafer 1 and another second semiconductor wafer 2 as a supporting substrate to form a third semiconductor wafer 3, performing a first annealing on the post-bonding third semiconductor wafer 3;
3) thinning to target thickness through mechanical grinding;
4) then performing chemical mechanical polishing on the third semiconductor wafer 3, automatically stops after polishing to the surface of the first oxide layer 12, the pH value of the slurry of the chemical mechanical polishing is 11, the particle size of the slurry is 50 nm;
5) performing a second annealing, the oxygen partial pressure of the annealing is 3 %;
6) then using a dilute HF solution to etch the first oxide layer 12 to obtain a silicon-on-insulator material with low defect density, the concentration of the HF solution is 3 %, the temperature of the HF solution is 20 °C.

The preparation methods of Examples 2 to 12 are the same as Example 1, the difference lies in that the settings of the condition parameter are different, refers to Table 1 for details.

Comparing the number of particles of the surface defect of the silicon-on-insulator substrate prepared by the preparation method of the embodiment and the silicon-on-insulator substrate prepared by the traditional oxygen implantation bonding process, the results are shown in FIG. 12 and FIG. 13, it can be seen that the number of particles of the surface defect of the silicon-on-insulator substrate prepared using the preparation method of the present application is significantly reduced.

Comparing the number of particles of the surface defect of the silicon-on-insulator substrate prepared in Example 1 to 12, the results are shown in Table 1.

**Table 1**

| | the pH value of the slurry of the chemical mechanical polishing | the particle size of the slurry of the chemical mechanical polishing (nm) | the oxygen partial pressure of the second annealing (%) | the concentration of the HF solution (%) | the temperature of the HF solution (°C) | the number of the surface defects of the silicon-on-insulator substrate (diameter of the defect particle is greater than or equal to 0.12 µm) |
|---|---|---|---|---|---|---|
| Example 1 | 11 | 50 | 3 | 3 | 20 | 4 |
| Example 2 | 11 | 45 | 3 | 3 | 20 | 3 |
| Example 3 | 11 | 40 | 3 | 3 | 20 | 2 |
| Example 4 | 10.5 | 45 | 3 | 3 | 20 | 4 |
| Example 5 | 10 | 45 | 3 | 3 | 20 | 9 |
| Example 6 | 11 | 45 | 5 | 3 | 20 | 5 |
| Example 7 | 11 | 45 | 20 | 3 | 20 | 5 |
| Example 8 | 10 | 45 | 3 | 3 | 20 | 6 |
| Example 9 | 11 | 45 | 3 | 5 | 20 | 3 |
| Example 10 | 11 | 45 | 3 | 20 | 20 | 5 |
| Example 11 | 11 | 45 | 3 | 3 | 30 | 4 |
| Example 12 | 11 | 45 | 3 | 3 | 40 | 5 |

As can be seen from Table 1, except for Example 5 and Example 8, the number of particles of the surface defect in other examples is less than or equal to 5, indicating that the number of particles of the surface defect of the silicon-on-insulator substrate prepared using the preparation method of the present application is significantly reduced. The pH value of the slurry of the chemical mechanical polishing of Example 5 and Example 8 is not within the scope of this application, indicating that the pH value of the slurry of the chemical mechanical polishing will affect the number of the final surface defects, if the pH value is too low, the selectivity of the polishing and removing will become worse, thus the pH value of the slurry of the chemical mechanical polishing needs to be controlled within the range of this application.

This application uses chemical mechanical polishing instead of alkali etching to avoid the silicon island defect 51 from extending below the oxide layer after being etched by alkali, and adds a second annealing and introduces oxygen to oxidize the silicon island defects 51 to facilitate the subsequent removal, thereby obtaining silicon-on-insulator substrate with a low defect density.

The silicon-on-insulator substrate and the preparation method thereof provided by the present application have been introduced in detail above. Specific examples are used in this article to illustrate the principles and implementation methods of the present application. The description of the above embodiments is only used to help understanding. The method of this application and its core idea; at the same time, for those skilled in the art, there will be changes in the specific implementation and application scope based on the ideas of this application. In summary, the contents of this specification should not be understood as a limitation on this application.

## Claims

1. A preparation method of a silicon-on-insulator substrate, comprising:
providing a first semiconductor wafer (1), the first semiconductor wafer (1) comprises a first monocrystalline silicon layer (11), a first oxide layer (12) and a first substrate silicon layer (13), the first oxide layer (12) is disposed between the first monocrystalline silicon layer (11) and the first substrate silicon layer (13), wherein, the first oxide layer (12) is formed through separation by implanted oxygen;
providing a second semiconductor wafer (2), the second semiconductor wafer (2) comprises a second substrate silicon layer (22) and a second oxide layer (21) disposed on the second substrate silicon layer (22);
bonding the first semiconductor wafer (1) and the second semiconductor wafer (2) to form a third semiconductor wafer (3), performing a first annealing on the third semiconductor wafer (3);
performing mechanical grinding on the first substrate silicon layer (13) to thin the first substrate silicon layer (13);
performing chemical mechanical polishing on the first substrate silicon layer (13) to polish to the surface of the first oxide layer (12);
performing a second annealing on the third semiconductor wafer (3), introducing argon and oxygen during the process of the second annealing;
etching the first oxide layer (12) by using a chemical etchant to obtain the silicon-on-insulator substrate.

2. The preparation method of a silicon-on-insulator substrate according to claim 1, wherein in the step of bonding the first semiconductor wafer (1) and the second semiconductor wafer (2) to form a third semiconductor wafer (3), comprises disposing the first semiconductor wafer (1) on the second semiconductor wafer (2), and contacting the first monocrystalline silicon layer (11) with the second oxide layer (21) to form the third semiconductor wafer (3) by bonding.

3. The preparation method of a silicon-on-insulator substrate according to any one of claims 1 to 2, wherein the second oxide layer (21) is a thermal oxide layer formed by dry oxygen oxidation or wet oxygen oxidation.

4. The preparation method of a silicon-on-insulator substrate according to any one of claims 1 to 3, wherein the temperature of the first annealing is lower than the temperature of the second annealing.

5. The preparation method of a silicon-on-insulator substrate according to any one of claims 1 to 4, wherein in the first annealing, the annealing temperature is 300 °C to 700 °C, the annealing duration is 2 hours to 4 hours.

6. The preparation method of a silicon-on-insulator substrate according to any one of claims 1 to 5, wherein in the second annealing, the annealing temperature is 800 °C to 1200 °C, the annealing duration is 4 hours to 6 hours, the oxygen partial pressure ratio is 3% to 20%.

7. The preparation method of a silicon-on-insulator substrate according to any one of claims 1 to 6, wherein after the first annealing, the bonding force of the third semiconductor wafer (3) is greater than or equal to 1.5 J/m²; after the second annealing, the bonding force of the third semiconductor wafer (3) is greater than or equal to 2 J/m².

8. The preparation method of a silicon-on-insulator substrate according to any one of claims 1 to 7, wherein the duration of the mechanical grinding and thinning is t₁ min, the duration of the chemical mechanical polishing is t₂ min, satisfying: 10 ≤ t₁ + t₂ ≤ 20.

9. The preparation method of a silicon-on-insulator substrate according to any one of claims 1 to 8, wherein the duration of the mechanical grinding and thinning is t₁ min, the duration of the chemical mechanical polishing is t₂ min, satisfying: 5 ≤ t₁ ≤ 10, and 5 ≤ t₂ ≤ 10.

10. The preparation method of a silicon-on-insulator substrate according to any one of claims 1 to 9, wherein in the step of mechanical grinding, after the first substrate silicon layer (13) is thinned, the thickness of the first substrate silicon layer (13) obtained is 5 to 10µm.

11. The preparation method of a silicon-on-insulator substrate according to any one of claims 1 to 10, wherein after the mechanical grinding and thinning, the thinned first substrate silicon layer (13) is obtained, the thinned first substrate silicon layer (13) comprises a reserved damage layer.

12. The preparation method of a silicon-on-insulator substrate according to any one of claims 1 to 11, wherein in the step of the chemical mechanical polishing, removing the reserved damage layer firstly, then stop when polishing to the surface of the first oxide layer (12).

13. The preparation method of a silicon-on-insulator substrate according to any one of claims 1 to 12, wherein the thickness of the reserved damage layer is 3 to 5µm.

14. The preparation method of a silicon-on-insulator substrate according to any one of claims 1 to 13, wherein the pH value of the slurry adopted by the chemical mechanical polishing is greater than or equal to 10.5, the particle size of the slurry is less than or equal to 50 nm.

15. The preparation method of a silicon-on-insulator substrate according to any one of claims 1 to 14, wherein the temperature of the chemical mechanical polishing is 20 °C to 40 °C, the removal rate of the chemical mechanical polishing is 0.5µm/min to 1µm/min.

16. The preparation method of a silicon-on-insulator substrate according to any one of claims 1 to 15, wherein the chemical etchant comprises a hydrofluoric acid solution, the concentration of the hydrofluoric acid solution is 3 % to 20 %, the temperature of the hydrofluoric acid solution is 20 °C to 40 °C.

17. A silicon-on-insulator substrate, wherein the silicon-on-insulator substrate is prepared by the preparation method according to any one of claims 1 to 16, the silicon-on-insulator substrate comprises a top silicon layer (41), an oxide layer (42) and a substrate silicon layer (43), the oxide layer (42) is disposed between the top silicon layer (41) and the substrate silicon layer (43), the number of particles of the surface defect of the top silicon layer (41) is less than or equal to 5.

18. The silicon-on-insulator substrate according to claim 17, wherein the thickness of the oxide layer (42) is 20 to 4000 nm.
